(19)

Europäisches Patentamt
European Patent Office
Office européen des brevets

(11) **EP 3 624 205 A1**

(12) **EUROPEAN PATENT APPLICATION**

(43) Date of publication:
**18.03.2020 Bulletin 2020/12**

(21) Application number: **18306199.3**

(22) Date of filing: **14.09.2018**

(51) Int Cl.:
*H01L 33/00* (2010.01)    *H01L 33/06* (2010.01)
*H01L 33/30* (2010.01)    *H01S 5/343* (2006.01)
*H01S 5/34* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Nokia Technologies Oy
02610 Espoo (FI)**

(72) Inventor: **GARREAU, Alexandre
92160 Antony (FR)**

(74) Representative: **Nokia EPO representatives
Nokia Technologies Oy
Karakaari 7
02610 Espoo (FI)**

(54) **METHOD FOR GENERATING QUANTUM WELL FOR LIGHT EMITTING DEVICES, AND ASSOCIATED LIGHT EMITTING DEVICES**

(57)    An epitaxy growth method for a III-V materials quantum well (100) comprising the step of generating a strained quantum well for reducing well for heavy holes in the valence band (121).

Fig. 1

**Description**

**FIELD OF THE INVENTION**

The present invention relates to optical components, in particular to light emitting devices.

**BACKGROUND OF THE INVENTION**

Durability, power consumption, versatility are trends of improvement of light emitting devices. Light emitting diodes (LED) are progressively proving they can replace incandescent light bulb or halogen lamp.

Some semiconductor material provide new platform for light emitting devices and optoelectronics devices. Aluminium Gallium Indium Phosphide (AlGaInP) or Aluminium Gallium Indium Nitride (AlGaInN) materials from the III-V compounds are used in combination with electro-stimulation to produce LED or laser diodes.

LED based on AlGaInN and AlGaInP are better suited for wavelengths corresponding to blue (450-495 nm) and red (620-750 nm) respectively. Yellow light (560-580 nm) emitting diodes may be based on direct band gap transition of III-V materials. For example Multiple Quantum Wells (MQW) have allowed to increase the External Quantum Efficiency (EQE) and have permitted to decrease the current injection. However at present the performance for yellow light production based on III-V lab are not satisfactory.

One solution for producing yellow light with III-V materials is achieved with a Single Quantum Well (SQW) emitted based on Aluminium (Al) migration by thermal annealing. This solution suffers some drawbacks: the thermal annealing can damaged the structures of the devices rendering the fabrication process harder and less efficient, and the Al migration originates from thick Al rich barriers which limits the number of quantum wells to a single well leading to a reduced ratio between output optical power and current injection.

It is therefore needed to design an improved light emitting device based on III-V materials.

**SUMMARY OF THE INVENTION**

The invention aims to remedy all or some of the disadvantages of the above identified prior art. It particularly proposes an improved design of light emitting device based on III-V materials.

A first example embodiment relates then to an epitaxy growth method for a III-V materials quantum well comprising the step of generating a strained quantum well for reducing well for heavy holes in the valence band.

Thus, thanks to these features, the epitaxy growth method allows to generate a strained quantum well with no or few heavy hole in the valence band. The induced lattice mismatch between the well and the barrier for generating the strained quantum well favors the light hole band rather than the heavy hole band.

Another example embodiment relates also to a method to fabricate a III-V materials semiconductor comprising the steps of:

- epitaxing a quantum well according to exemplary embodiments,
- layering a second barrier on the well, said well being in-between the first barrier and the second barrier,
- layering a n-type layer on the first barrier,
- layering a p-type layer on the second barrier,
- layering a substrate layer on the n-type layer.

Thus, thanks to these features, it is possible to fabricate a III-V materials semiconductor with a strained quantum well with no or few heavy hole in the valence band. The induced lattice mismatch between the well and the barrier for generating the strained quantum well favors the light hole band rather than the heavy hole band. Another example embodiment relates also to a III-V materials quantum well comprising a well comprising III-V materials Al(x)Ga(0.53)In(0.47-x)P layer, where:

- Al is the aluminum III-V materials,
- Ga is the gallium III-V materials,
- In is the indium III-V materials,
- P is the phosphide III-V materials,
- x is the mole fraction of the Aluminium.

Thus, thanks to these features, the III-V materials quantum well comprises a strained quantum well with no or few heavy hole in the valence band. The induced lattice mismatch between the well and the barrier for generating the strained quantum well favors the light hole band rather than the heavy hole band.

Another example embodiment relates also to a semiconductor device comprising the III-V quantum well according to exemplary embodiments.

Thus, thanks to these features, the semiconductor device offers a better ratio of output power versus the current injection thanks to prominence of the light hole band.

According to various embodiments the epitaxy growth method for a III-V materials quantum well, the method to fabricate a III-V materials semiconductor, the III-V materials quantum well, the semiconductor device, further comprise respectively one or more of the following features below, which should be considered in any possible technical combinations.

In an embodiment, the generation a strained quantum well further confines light holes in well for creating gain with limited valence band offset.

In an embodiment, an interband transition from the interval 590nm-620nm to the intervals 575nm-585nm and/or 495nm-570nm is realized by defining a stoechiometry of the III-V materials from the quantum well.

In an embodiment, the quantum well comprises a well and a first barrier, the well being applied with a biaxial tension, and the first barrier being applied with a biaxial compression.

In an embodiment, applying the biaxial tension on the well and applying the biaxial compression on the first barrier define a lattice mismatch between said well and said barrier, the obtained quantum well being a strained quantum well.

In an embodiment, the heavy hole band are suppressed from the quantum well, and, an interband transition is realized between the light holes band and the conduction band, said suppression and realization favoring a transverse polarization mode.

In an embodiment, the thickness of the quantum well is defined according to a stoechiometry of the III-V materials from the quantum well.

In yet another embodiment, a stoechiometry of the III-V materials from the quantum well is defined according to a chosen thickness of the quantum well.

In an embodiment, the well comprises III-V materials $Al(x)Ga(0.53)In(0.47-x)P$ layer, where Al is the aluminium III-V materials, Ga is the gallium III-V materials, In is the indium III-V materials, P is the phosphide III-V materials, x is the mole fraction of the Aluminium.

In an embodiment, the first barrier comprises III-V materials $Al(0.3)Ga(0.2)In(0.5)P$ layer.

In an embodiment, the III-V materials semiconductor is fabricated so that it comprises:

- the second barrier comprising III-V materials $Al(0.3)Ga(0.2)In(0.5)P$ layer,
- the n-type layer comprising III-V materials n-InGaP,
- the p-type layer comprising III-V materials p-InGaP,
- the substrate layer comprises III-V materials GaAs.

In an embodiment, the x mole fraction of the Aluminium of the III-V materials quantum well is greater or equal than 0.06 and/or inferior or equal than 0.12.

In an embodiment, the thickness of the well of the III-V materials quantum well is comprised in the interval 4 nm to 6 nm.

In an embodiment, the x mole fraction of the Aluminium of the III-V materials quantum well is 0.06, and the thickness of the well of the III-V materials quantum well is comprised in the interval 4 nm to 6 nm, preferably the thickness of the well equals 6 nm.

In an embodiment, the x mole fraction of the Aluminium of the III-V materials quantum well is 0.07, and the thickness of the well of the III-V materials quantum well is comprised in the interval 4 nm to 6 nm, preferably the thickness of the well equals 6 nm.

In an embodiment, the x mole fraction of the Aluminium of the III-V materials quantum well is 0.08, and the thickness of the well of the III-V materials quantum well is comprised in the interval 4 nm to 6 nm, preferably the thickness of the well equals 5 nm.

In an embodiment, the x mole fraction of the Aluminium of the III-V materials quantum well is 0.09, and the thickness of the well of the III-V materials quantum well is comprised in the interval 4 nm to 6 nm, preferably the thickness of the well equals 5 nm.

In an embodiment, the x mole fraction of the Aluminium of the III-V materials quantum well is 0.95, and the thickness of the well of the III-V materials quantum well is comprised in the interval 4 nm to 6 nm, preferably the thickness of the well equals 5 nm.

In an embodiment, the x mole fraction of the Aluminium of the III-V materials quantum well is 0.1, and the thickness of the well of the III-V materials quantum well is comprised in the interval 4 nm to 6 nm, preferably the thickness of the well equals 4 nm.

In an embodiment, the x mole fraction of the Aluminium of the III-V materials quantum well is 0.11, and the thickness of the well of the III-V materials quantum well is comprised in the interval 4 nm to 6 nm, preferably the thickness of the well equals 6 nm.

In an embodiment, the x mole fraction of the Aluminium of the III-V materials quantum well is 0.12, and the thickness of the well of the III-V materials quantum well is comprised in the interval 4 nm to 6 nm, preferably the thickness of the well equals 6 nm.

In an embodiment, the semiconductor device comprising the III-V materials quantum well according to hereinabove embodiments is a laser diode.

In an embodiment, the semiconductor device comprising the III-V materials quantum well according to hereinabove embodiments is a light-emitting diode.

Thus, thanks to these features, the thickness of the well and the x mole of fraction of aluminium allows to build a quantum well from III-V materials suitable for light-emitting semiconductors, in particular that are very efficient in the production of yellow light and green light.

**BRIEF DESCRIPTION OF THE FIGURES**

Some embodiments are now described, by way of example only, and with reference to the accompanying drawings in which:

- FIG. 1 is a schematic block diagram of a quantum well,
- FIG. 2a is a plot of the gain of a 6nm $Ga_{0.43}Al_{0.1}In_{0.5}P$ / 80nm $Al_{0.27}Ga_{0.23}In_{0.5}P$ single quantum well,
- FIG. 2b is a plot of the gain of a 4nm $Ga_{0.43}Al_{0.1}In_{0.5}P$ / 80nm $Al_{0.27}Ga_{0.23}In_{0.5}P$ single quantum well,
- FIG. 3 is a plot of wavelength of maximum Gain and maximum gain in function of x the mole fraction of aluminum for 6nm $Al_xGa_{0.53}In_{0.47-x}P$ / $Al_{0.3}Ga_{0.2}In_{0.5}P$ quantum well according to exemplary embodiments.
- FIG. 4 is a plot of transition energies in function of x the mole fraction of aluminum for 6 nm $Al(x)Ga(0.53)In(0.47-x)P$ / $Al(0.3)Ga(0.2)In(0.5)P$ quantum well according to exemplary embodiments,
- FIG. 5 is a plot of the gain of the Transverse Electric (TE) mode as a function of the wavelength for 5nm $Al_{0.09}Ga_{0.53}In_{0.38}P$ / $Al_{0.3}Ga_{0.2}In_{0.5}P$ quantum well according to exemplary embodiments,
- FIG. 6 is a plot of the gain of the Transverse Magnetic (TM) mode as a function of the wavelength for 5nm $Al_{0.09}Ga_{0.53}In_{0.38}P$ / $Al_{0.3}Ga_{0.2}In_{0.5}P$ quantum well according to exemplary embodiments.

The same reference number represents the same element to the same type of element on all drawings, unless stated otherwise.

**DESCRIPTION OF EMBODIMENTS**

The figures and the following description illustrate specific exemplary embodiments of the invention. It will thus be appreciated that those skilled in the art will be able to devise various arrangements that, although not explicitly described or 30 shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

In the following description, well-known functions or constructions by the man skilled in the art are not described in detail since they would obscure the invention in unnecessary detail.

In the following description of the figures, schematic representations are non-limiting and serve only for the understanding of the invention.

In the following description, the compounds may be written with their respective presence in parenthesis (compound A(d)B(e)C(f) with 'd' mole fraction of 'A', 'e' mole fraction of B and 'f' mole fraction of C) or in indices (same compound $A_dB_eC_f$ with 'd' mole fraction of 'A', 'e' mole fraction of B and 'f' mole fraction of C).

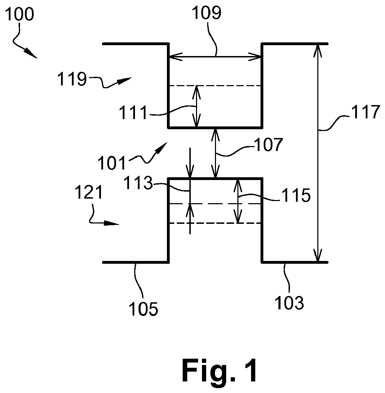

Referring to figure FIG.1, a schematic block diagram of a quantum well is depicted.

A quantum well 100 is defined by a well 101 defined by a material and a thickness 109 and barriers (first barrier 103 and second barrier 105) also defined by respective materials and respective thicknesses located on both sides of the well. In an example, a laser structure has a single quantum well InGaP / AlGaInP sandwiched between Indium Aluminium Phosphide (InAlP) cladding layers and Gallium Arsenide (GaAs) substrate. The materials of the well and the barriers have a gap energy respectively $E_{G\ Well}$ 107 and $E_{G\ Barrier}$ 117. The quantum well is also defined by its quantified energies, $\Delta E_c$ 111 in the conduction band 119, $\Delta E_{lh}$ 115 for light holes in the valence band 121 and $\Delta E_{hh}$ 113 for heavy holes in the valence band 121. The transition energy is the sum either of $\Delta E_c + E_{G\ Well} + \Delta E_{lh}$ or $\Delta E_c + E_{G\ Well} + \Delta E_{hh}$.

One of the quantum well intermixing (QWI) technique induces a large degree of band gap blue shift in the Indium Gallium Phosphide (InGaP) / Indium Aluminium Gallium Phosphide (InAlGaP) laser structure. A band gap blue shift as large as 200meV may be observed in samples capped with Silicon dioxide ($SiO_2$) layer and annealed at 1000°C for 120s. To further enhance the degree of QWI, cycles of annealing steps are applied to the $SiO_2$ cap. This technique allows wavelength tunability over the range of 640 nm to 565 nm. Light-emitting diodes emitting at red (628nm), orange (602nm), and yellow (585nm) wavelengths may be fabricated on the intermixed samples.

The initial structure is based on a Single Quantum Well (SQW) composed of a 6nm $Ga_{0.53}In_{0.47}P$ well and 80nm $Al_{0.27}Ga_{0.23}In_{0.5}P$ barriers (where the indices denote the respective mole fraction of the material). Both materials are lattice matched with Gallium Arsenide (GaAs) substrate. The QWI produces a migration of aluminum atoms from the barrier to the well.

This migration may be quantified experimentally. By considering that the new material is always lattice matched, the SQW is composed of $Ga_{0.53-y}Al_yIn_{0.47}P$ well and $Al_{0.27}Ga_{0.23}In_{0.5}P$ barriers, where y indices denotes the mole fraction of the Aluminium material. The thickness of the barriers allows them to behave as aluminum tank and with the same stoechiometry. By modeling the quantum well with a modeling tool (for example BCBV software relating to the Thesis "Modélisation et simulation des composants optoélectroniques a puits quantiques », Nicolas Trenado 2002, https://tel.archives-ouvertes.fr/tel-00010221), in an embodiment, it appears a 23nm blue shift of the gain maximum wavelength in function of aluminum incorporation in the SQW (Table 1a).

Table 1a: 6nm $Ga_{0.53-y}Al_yIn_{0.47}P$ / 80nm $Al_{0.27}Ga_{0.23}In_{0.5}P$ SQW

| III-V elements Stoechiometry | | | |
|---|---|---|---|
| Ga | Al | In | Wavelength of gain maximum (nm) |
| 0,53 | 0 | 0,47 | 618 |
| 0,505 | 0,025 | 0,47 | 612 |
| 0,48 | 0,05 | 0,47 | 610 |
| 0,465 | 0,075 | 0,47 | 600 |
| 0,43 | 0,1 | 0,47 | 595 |
| | | | |
| Ga | Al | In | Well thickness (nm) |
| 0,43 | 0,1 | 0,47 | 6 |
| 0,43 | 0,1 | 0,47 | 5 |
| 0,43 | 0,1 | 0,47 | 4 |
| | | | |
| Ga | Al | In | Well thickness (nm) |
| 0,53 | 0,12 | 0,35 | 6 |
| 0,53 | 0,11 | 0,36 | 6 |
| 0,53 | 0,1 | 0,37 | 6 |
| 0,53 | 0,095 | 0,375 | 6 |

In an embodiment, by taking into account the aluminum incorporation and also a decrease of quantum well thickness (Table 1b), it appears a 31nm blue shift of the gain maximum wavelength, which is closed to the observed 38nm shift result from the above QWI technique for light emitting diodes.

Table 1b: 6nm $Ga_{0.43}Al_{0.1}In_{0.5}P$ / 80nm $Al_{0.27}Ga_{0.23}In_{0.5}P$ SQW

| III-V elements Stoechiometry | | | | |
|---|---|---|---|---|
| Ga | Al | In | Well thickness (nm) | Wavelength of gain maximum (nm) |
| 0,43 | 0,1 | 0,47 | 6 | 597 |
| 0,43 | 0,1 | 0,47 | 5 | 594 |
| 0,43 | 0,1 | 0,47 | 4 | 590 |

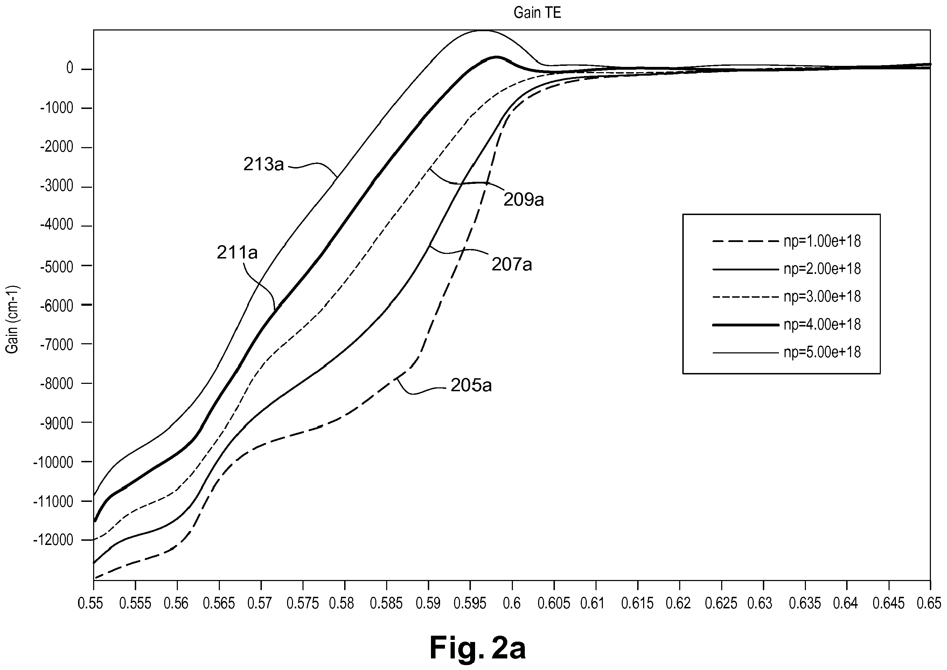

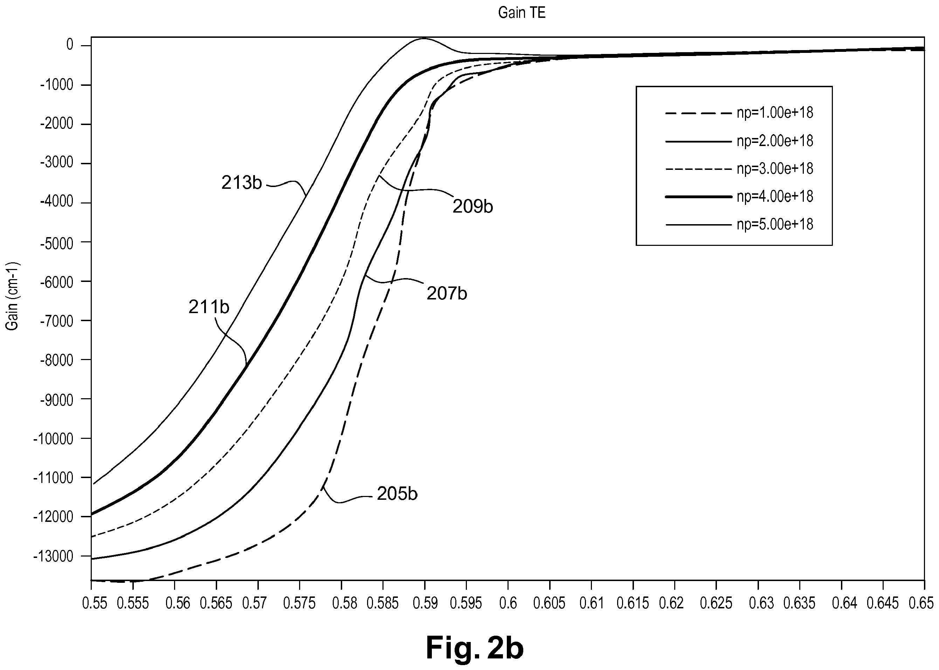

Referring to figure FIG. 2a a plot of the gain of a 6nm $Ga_{0.43}Al_{0.1}In_{0.5}P$ / 80nm $Al_{0.27}Ga_{0.23}In_{0.5}P$ single quantum well is depicted. Referring also to figure FIG. 2b, a plot of the gain of a 6nm $Ga_{0.43}Al_{0.1}In_{0.5}P$ / 80nm $Al_{0.27}Ga_{0.23}In_{0.5}P$ single quantum well is depicted. The figures FIG. 2a and FIG. 2b provide estimated gains curves for different wavelengths and different densities of carriers injected (np) in wells of different thickness are plotted.

The respective x-axis of figures FIG. 2a and FIG. 2b represent wavelengths in micrometers ($\mu$m). The respective y-axis of figures FIG. 2a and FIG. 2b represent the gain in units of $cm^{-1}$, with a scale of $1000\ cm^{-1}$.

The gain curves of figure FIG. 2a are as follows:

- curve 205a: gain curve as a function of the wavelength for a density of carriers injected in the well of $1.00e^{18}\ cm^{-3}$,
- curve 207a: gain curve as a function of the wavelength for a density of carriers injected in the well of $2.00e^{18}\ cm^{-3}$,
- curve 209a: gain curve as a function of the wavelength for a density of carriers injected in the well of $3.00e^{18}\ cm^{-3}$,
- curve 211a: gain curve as a function of the wavelength for a density of carriers injected in the well of $4.00e^{18}\ cm^{-3}$,
- curve 213a: gain curve as a function of the wavelength for a density of carriers injected in the well of $5.00e^{18}\ cm^{-3}$.

The gain curves of figure FIG. 2b are as follows:

- curve 205b: gain curve as a function of the wavelength for a density of carriers injected in the well of $1.00e^{18}\ cm^{-3}$,
- curve 207b: gain curve as a function of the wavelength for a density of carriers injected in the well of $2.00e^{18}\ cm^{-3}$,
- curve 209b: gain curve as a function of the wavelength for a density of carriers injected in the well of $3.00e^{18}\ cm^{-3}$,
- curve 211b: gain curve as a function of the wavelength for a density of carriers injected in the well of $4.00e^{18}\ cm^{-3}$,
- curve 213b: gain curve as a function of the wavelength for a density of carriers injected in the well of $5.00e^{18}\ cm^{-3}$.

Referring to figure FIG. 2a, in the Transverse Electric polarization mode, the estimated maximum gain calculated at 597 nm is around $710\ cm^{-1}$ (maximum of the curve 213a). Referring to figure FIG. 2b, in the Transverse Electric polarization mode, the estimated maximum gain calculated at 590 nm is around $210\ cm^{-1}$ (maximum of the curve 213b). The estimated maximum gains when considering the approach of Aluminum incorporation are not satisfactory.

Considering these observations and the experimental results, the inventors designed an AlGaInP quantum well from orange light to yellow-green light.

In an embodiment, an epitaxy growth method for a III-V materials quantum well comprises the step of generating a strained quantum well. Advantageously the step of generating said strained quantum well reduces well for heavy hole in the valence band.

Advantageously such epitaxy growth method allows to design a method to fabricate a III-V materials semiconductor comprising the step of epitaxing a quantum well with a strained quantum well, layered between a first barrier and a second barrier, said second barrier being layered by a p-type barrier, and said first barrier being layered by a n-type layer, a layering substrate layering the n-type layer.

In an embodiment, the quantum well is obtained by direct epitaxy of the multi quantum wells. Advantageously harmful thermal annealing is not required.

In another embodiment, rules for stoechiometry of the AlGaInP quantum are defined in order to realize an interband transition from orange to yellow-green.

In yet another embodiment, a lattice mismatch between the well and the barrier is defined in order to generate a strained quantum well which favors the light hole band rather than the heavy hole band. It should be noted that it is meant by lattice constant matching, in epitaxied growth method, a measure of the structure compatibility between the different materials. As such a lattice mismatch is then a measurable offset between the alignments of the structures. Lattice mismatching may induce increase strain in-between the structures.

In yet another embodiment, the Transverse Magnetic (TM) polarization mode is favored thanks to interband transition between the light hole band the conduction band, by reducing or suppressing the heavy hole band.

In yet another embodiment, rules for the thickness of the quantum well in function of the stoechiometry of AlGaInP quantum well are defined for optimizing the gain. These rules enables the confinement of $\Delta E_{lh}$ light hole valence energy and $\Delta E_c$ conduction energy.

Yellow-green light are usually produced by quantum well comprising $Al_xGa_{0.53-x}In_{0.47}P$ material for the well and $Al_{0.27}Ga_{0.23}In_{0.5}P$ material for the barriers, where x represents the mole fraction of the Aluminium material. The materials $Al_xGa_{0.53-x}In_{0.47}P$ and $Al_{0.27}Ga_{0.23}In_{0.5}P$ are lattice matched with the GaAs substrate. In an embodiment, a strain is induced in order to generate a strained quantum well with limited well for heavy hole in the valence band, preferably with no well for heavy hole in said valence band.

In an embodiment, for producing a strained quantum well, the well is set under a biaxial tension. Such biaxial tension is achieved by defining the lattice constant a(x) of the well below the lattice constant of GaAs substrate $a_{GaAs}$.

In a further embodiment, the production of the strained quantum well uses the barrier under a biaxial compression. Such biaxial compression is achieved by defining the lattice constant over the lattice constant of GaAs substrate

$a_{GaAs}$.

It should be noted that the strained quantum well may be achieved through the combined effects of the biaxial compression and the biaxial tension. It may be achieved also with one of these effects being more prominent than the other one.

It should also be noted that the biaxial tension on the well and the biaxial compression on the barrier define a lattice mismatch between the well and the barrier.

In yet another embodiment, the generation of the strained quantum well confines light holes in well for creating gain with limited valence band offset. It is meant by limited valence offset that the contribution of the well of the heavy holes in the valence band is small or drastically reduced. Advantageously such confinement of the light holes favors the TM polarization mode.

In yet another embodiment, the strained quantum well is generated by realizing an interband transition from the interval 590nm-620nm to the intervals 575nm-585nm and/or 495nm-570nm, by defining a stoechiometry of the III-V materials from the quantum well.

In an embodiment, the well is defined by the stoechiometry of the layer of $Al_xGa_{0.53}In_{0.47-x}P$, where x is the mole fraction of the Aluminium material. In an example, the more prominent is the Aluminium (with a higher x mole fraction of Aluminium), the more the well is under biaxial tension. The elastic strain $E_{xx}$ is defined according to equation (1). The gain maximum for a given x mole fraction of Aluminium is provided by equation (2). The achievable wavelength of the gain maximum is provided by equation (3).

$$(1) \quad E_{xx} = (a(x) - a_{GaAs})/a_{GaAs}$$

$$(2) \quad \text{Gain maximum } (cm^{-1}) = 279.85e^{21.754x}$$

$$(3) \quad \text{Wavelength } (nm) = -442.04x + 618.32$$

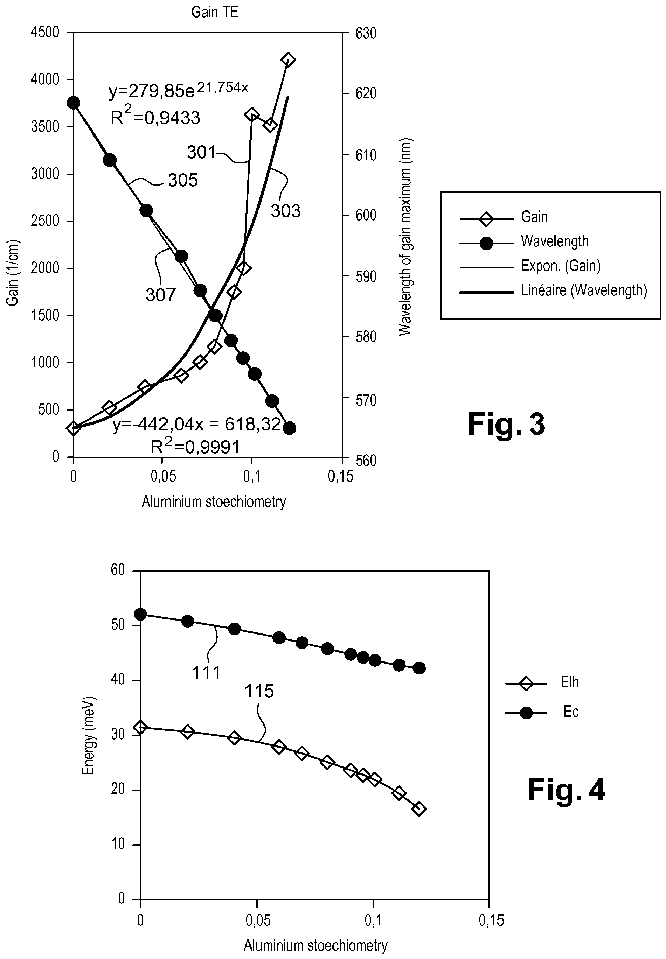

Referring to figure FIG.3, a curve of the gain maximum (left y-axis) and wavelength maximum gain (right y-axis) as a function of the stoechiometry of the 6nm $Al_xGa_{0.53}In_{0.47-x}P$ / $Al_{0.3}Ga_{0.2}In_{0.5}P$ quantum well, in particular as a function of x mole fraction of Aluminium. The curve 301 depicts the gain curve as a function of the Aluminium stoechiometry, and the curve 303 corresponds to the gain curve 301 in exponential scale. The curve 305 depicts the evolution of the achievable wavelength as a function of the Aluminium stoechiometry. The curve 307 is the linear representation of the wavelength curve 305.

In the example of figure FIG. 3, from x equals to 0.7, the TM gain, which is taking into account the effect of the gap renormalization due to the carrier' injection, increases. The increase of the TM gain is noticeable from the portion of 300-400 $cm^{-1}$ where the layers are lattice matched, to the portion of 2000 $cm^{-1}$ where the strained quantum well is achieved. The reduction or the absence of well for heavy holes in the valence band also favors the TM mode and as such an increased TM gain.

In the example of figure FIG. 3, the transition energy $\Delta E_c + E_{G\,Well} + \Delta E_{lh}$, and consequently the wavelength of the gain maximum, may be tuned as a function of x mole fraction of Aluminium. The stoechiometry from $Al_xGa_{0.53}In_{0.47-x}P$ allows then to determine a particular wavelength as per equation (3). Examples of gain maximum, as a function of x mole fraction of Al, and for a 6nm quantum well are provided by table 2.

Table 2

| Ga stoichio-metry | Al stoichio-metry | In stoichio-metry | Thickness (nm) | Gain (cm-1) | Gain maximum (nm) | Exx | ΔEc (meV) | ΔElh (meV) |
|---|---|---|---|---|---|---|---|---|
| 0.53 | 0.12 | 0.35 | 6 | 4200 | 565 | 8.12E-03 | 42.3 | 16.8 |
| 0.53 | 0.11 | 0.36 | 6 | 3500 | 570 | 8.12E-03 | 43 | 19.7 |
| 0.53 | 0.1 | 0.37 | 6 | 3600 | 574 | 7.31E-03 | 44 | 22 |

(continued)

| Ga stoichio-metry | Al stoichio-metry | In stoichio-metry | Thickness (nm) | Gain (cm-1) | Gain maximum (nm) | Exx | $\Delta Ec$ (meV) | $\Delta Elh$ (meV) |
|---|---|---|---|---|---|---|---|---|
| 0.53 | 0.095 | 0.375 | 6 | 2000 | 576 | 6.91E-03 | 44 | 23 |
| 0.53 | 0.09 | 0.38 | 6 | 1750 | 578 | 6.52E-03 | 45 | 23.9 |
| 0.53 | 0.08 | 0.39 | 6 | 1200 | 583 | 5.76E-03 | 46 | 25.4 |
| 0.53 | 0.07 | 0.40 | 6 | 1000 | 587.5 | 5.76E-03 | 46.9 | 26.7 |
| 0.53 | 0.06 | 0.41 | 6 | 860 | 593 | 4.33E-03 | 47.8 | 27.8 |

Referring to figure FIG. 4, a curve of transition energies $\Delta E_c$ 111 and $\Delta E_{lh}$ 115 (y-axis) in function of x mole fraction of Aluminum (x-axis) for 6nm $Al_xGa_{0.53}In_{0.47-x}P$ / $Al_{0.3}Ga_{0.2}In_{0.5}P$ quantum well is depicted.

As the light hole barrier $\Delta E_{lh}$ 115 decreases the confinement of light hole decreases too. Upon a transition energy of 20meV, no more confinement for light hole is available. Such phenomenon does not happen for the electron barrier energy $\Delta E_c$ 111. In an embodiment, the thickness of the well is adjusted according to the gain maximum to be achieved. Such rule regarding the thickness allows to preserve the light hole confinement. In an example the light hole barrier $\Delta E_{lh}$ is increased to approximately 30meV and exhibiting an output gain maximum of 1000 cm$^{-1}$, whereas existing solutions are much less efficient.

In examples, various configurations for different wavelengths according to Aluminum stoichiometry and thickness are provided in table 3.

Table 3: exemplary embodiments of configurations of Quantum Well, in particular from orange light to yellow light / green light.

| Aluminum stoichio-metry | Thickness (nm) | Gain (cm-1) | Gain maximum (nm) | $E_{xx}$ | $\Delta Ec$ (meV) | $\Delta Elh$ (meV) |
|---|---|---|---|---|---|---|
| 0.1 | 6 | 3600 | 574 | 7.31E-03 | 44 | 22 |
| 0.1 | 5 | 4000 | 570 | 7.31E-03 | 54 | 26 |
| 0.1 | 4 | 2800 | 565 | 7.31E-03 | 69 | 32 |
| 0.95 | 6 | 2000 | 576 | 6.91E-03 | 44 | 23 |
| 0.95 | 5 | 1700 | 572 | 6.91E-03 | 55.4 | 27.8 |
| 0.95 | 4 | 500 | 576 | 6.91E-03 | 70 | 34 |
| 0.09 | 6 | 1750 | 578 | 6.52E-03 | 45 | 23.9 |
| 0.09 | 5 | 1200 | 577.5 | 6.52E-03 | 56 | 29 |
| 0.09 | 4 | 300 | 568 | 6.52E-03 | 71 | 35 |
| 0.08 | 6 | 1200 | 583 | 5.76E-03 | 46 | 25.4 |
| 0.08 | 5 | 930 | 579 | 5.76E-03 | 57 | 31.2 |
| 0.08 | 4 | 150 | 574 | 5.76E-03 | 72 | 38.8 |
| 0.07 | 6 | 1000 | 587.5 | 5.28E-03 | 46.9 | 26.7 |
| 0.07 | 5 | 350 | 584 | 5.28E-03 | 58.5 | 33 |
| 0.07 | 4 | 0 | 577 | 5.28E-03 | 74 | 41 |
| 0.06 | 6 | 860 | 593 | 4.33E-03 | 47.8 | 27.8 |

(continued)

| Aluminum stoichio-metry | Thickness (nm) | Gain (cm⁻¹) | Gain maximum (nm) | $E_{xx}$ | $\Delta Ec$ (meV) | $\Delta Elh$ (meV) |
|---|---|---|---|---|---|---|
| 0.06 | 5 | 100 | 588 | 4.33E-03 | 59.7 | 34.5 |
| 0.06 | 4 | 0 | 580 | 4.33E-03 | 76.2 | 43.6 |

In examples, the preferred configurations for yellow light / green light are provided by table 4.

Table 4: preferred exemplary embodiments of configurations of Quantum Well, in particular from orange light to yellow light / green light.

| Aluminum stoichio-metry | Thickness (nm) | Gain (cm⁻¹) | Gain maximum (nm) | $E_{xx}$ | $\Delta Ec$ (meV) | $\Delta Elh$ (meV) |
|---|---|---|---|---|---|---|
| 0.1 | 4 | 2800 | 565 | 7.31E-03 | 69 | 32 |
| 0.95 | 5 | 1700 | 572 | 6.91E-03 | 55.4 | 27.8 |
| 0.09 | 5 | 1200 | 577.5 | 6.52E-03 | 56 | 29 |
| 0.08 | 5 | 930 | 579 | 5.76E-03 | 57 | 31.2 |
| 0.07 | 6 | 1000 | 587.5 | 5.28E-03 | 46.9 | 26.7 |
| 0.06 | 6 | 860 | 593 | 4.33E-03 | 47.8 | 27.8 |

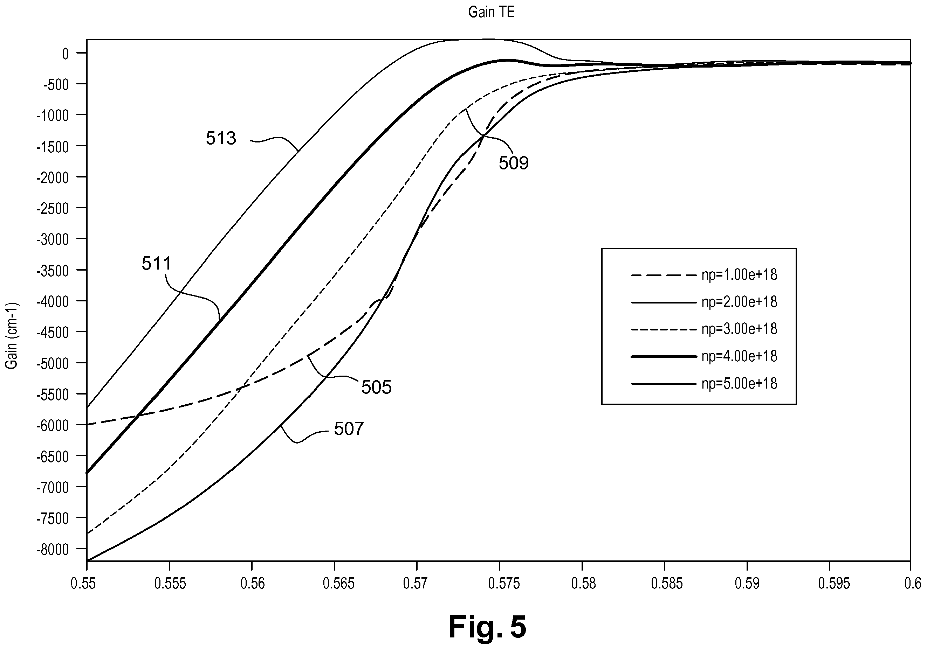

Referring to figure FIG. 5, a plot of the gains of the Transverse Electric (TE) mode (y-axis) as a function of the wavelength (x-axis) for 5nm $Al_{0.09}Ga0.53In_{0.38}P$ / $Al_{0.3}Ga_{0.2}In_{0.5}P$ quantum well, and for different densities of carriers injected in the well, according to exemplary embodiments is depicted.
The x-axis represents wavelengths in micrometers ($\mu$m). The y-axis represents the gain in unit of cm⁻¹, with a scale of 1000 cm⁻¹. The gain curves are as follows:

- curve 505: gain curve as a function of the wavelength for a density of carriers injected in the well of $1.00e^{18}$ cm⁻³,
- curve 507: gain curve as a function of the wavelength for a density of carriers injected in the well of $2.00e^{18}$ cm⁻³,
- curve 509: gain curve as a function of the wavelength for a density of carriers injected in the well of $3.00e^{18}$ cm⁻³,
- curve 511: gain curve as a function of the wavelength for a density of carriers injected in the well of $4.00e^{18}$ cm⁻³,
- curve 513: gain curve as a function of the wavelength for a density of carriers injected in the well of $5.00e^{18}$ cm⁻³.

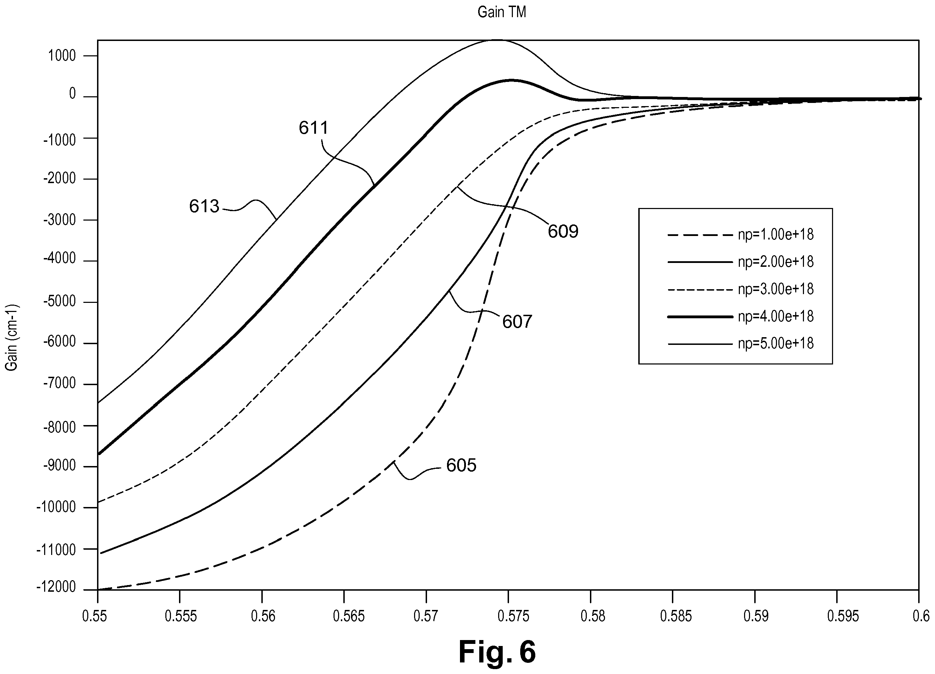

Referring to figure FIG. 6, a plot of the gain of the Transverse magnetic (TM) mode (y-axis) as a function of the wavelength (x-axis) for 5nm $Al_{0.09}Ga0.53In_{0.38}P$ / $Al_{0.3}Ga_{0.2}In_{0.5}P$ quantum well, and for different densities of carriers injected in the well, according to exemplary embodiments is depicted.
The x-axis represents wavelengths in micrometers ($\mu$m). The y-axis represents the gain in unit of cm⁻¹, with a scale of 1000 cm⁻¹. The gain curves are as follows:

- curve 605: gain curve as a function of the wavelength for a density of carriers injected in the well of $1.00e^{18}$ cm⁻³,
- curve 607: gain curve as a function of the wavelength for a density of carriers injected in the well of $2.00e^{18}$ cm⁻³,
- curve 609: gain curve as a function of the wavelength for a density of carriers injected in the well of $3.00e^{18}$ cm⁻³,
- curve 611: gain curve as a function of the wavelength for a density of carriers injected in the well of $4.00e^{18}$ cm⁻³,
- curve 613: gain curve as a function of the wavelength for a density of carriers injected in the well of $5.00e^{18}$ cm⁻³.

Advantageously the tuning of the Aluminium presence and the well thickness allows to favor the TM polarization mode rather than the TE polarization mode, which is beneficial for the efficiency of a semiconductor device based on exemplary embodiments. In an example where x=0.09, thickness=5 nm, the TM gain achieves 1200 cm⁻¹ at a wavelength around 575nm (figure FIG. 6, maximum of curve 613 at the wavelength around 0.575 $\mu$m) whereas the TE gain is limited to 300 cm⁻¹ (figure FIG. 5, maximum of curve 513 at the wavelength around 0.575 $\mu$m).
In an embodiment, a semiconductor device comprises III-V materials quantum well according to the above exemplary embodiments. In an example the semiconductor is a laser diode. In yet another example, the semiconductor device is a light-emitting device such a light emitting diode. Advantageously such semiconductor devices offer better performance in the production of yellow light and green light.

**Claims**

1. An epitaxy growth method for a III-V materials quantum well (100) comprising the step of generating a strained quantum well for reducing well for heavy holes in the valence band (121).

2. An epitaxy growth method according to claim 1, wherein the step of generating a strained quantum well further confines light holes in well for creating gain with limited valence band offset.

3. An epitaxy growth method according to any of the previous claims further comprising the step of realizing an interband transition from the interval 590nm-620nm to the intervals 575nm-585nm and/or 495nm-570nm, by defining a stoechiometry of the III-V materials from the quantum well.

4. An epitaxy growth method according to claim 1, wherein said quantum well comprising a well and a first barrier, the epitaxy growth method comprising the following steps of:

   - applying a biaxial tension on the well (101),
   - applying a biaxial compression on the first barrier (103).

5. An epitaxy growth method according to any of the previous claims, wherein the step of applying the biaxial tension on the well (101) and the step of applying the biaxial compression on the first barrier (103) define a lattice mismatch between said well (101) and said barrier (103), the obtained quantum well being a strained quantum well.

6. An epitaxy growth method according to any of the previous claims further comprising the steps of:

   - suppressing the heavy hole band from the quantum well, and,
   - realizing an interband transition between the light holes band and the conduction band,

   said steps of suppressing and realizing favoring a transverse magnetic polarization mode.

7. An epitaxy growth method according to any of the previous claims further comprising the step of:

   - defining a thickness of the quantum well according to a stoechiometry of the III-V materials from the quantum well.

8. An epitaxy growth method according to any of the previous claims, wherein the well comprises III-V materials Al(x)Ga(0.53)In(0.47-x)P layer, where:

   - Al is the aluminium III-V materials,
   - Ga is the gallium III-V materials,
   - In is the indium III-V materials,
   - P is the phosphide III-V materials,
   - x is the mole fraction of the Aluminium.

9. An epitaxy growth method according to any of the previous claims, wherein the first barrier comprises III-V materials Al(0.3)Ga(0.2)In(0.5)P layer.

10. A method to fabricate a III-V materials semiconductor comprising the steps of:

    - epitaxing a quantum well (100) according to any of the claims 4 to 7,
    - layering a second barrier (105) on the well (101), said well being in-between the first barrier (103) and the second barrier (105),
    - layering a n-type layer on the first barrier (103),
    - layering a p-type layer on the second barrier (105),
    - layering a substrate layer on the n-type layer.

11. A method to fabricate a III-V materials semiconductor according to claim 9, wherein:

    - the second barrier comprises III-V materials Al(0.3)Ga(0.2)In(0.5)P layer,

- the n-type layer comprises III-V materials n-InGaP,
- the p-type layer comprises III-V materials p-InGaP,
- the substrate layer comprises III-V materials GaAs.

12. A III-V materials quantum well comprising a well comprising III-V materials Al(x)Ga(0.53)In(0.47-x)P layer, where:

- Al is the aluminum III-V materials,
- Ga is the gallium III-V materials,
- In is the indium III-V materials,
- P is the phosphide III-V materials,
- x is the mole fraction of the Aluminium.

13. A III-V materials quantum well according to claim 12 where x is greater or equal than 0.06 and/or inferior or equal than 0.12.

14. A III-V materials quantum well according to any of the claims 12 to 13, wherein a thickness of the well is comprised in the interval 4nm to 6nm.

15. A III-V materials quantum well according to any of the claims 12 to 13, wherein:

- x equals 0.06,
- a thickness of the well is comprised in the interval 4nm to 6 nm, preferably the thickness of the well equals 6nm.

16. A III-V materials quantum well according to any of the claims 12 to 13, wherein:

- x equals 0.07,
- a thickness of the well is comprised in the interval 4nm to 6 nm, preferably the thickness of the well equals 6nm.

17. A III-V materials quantum well according to any of the claims 12 to 13, wherein:

- x equals 0.08,
- a thickness of the well is comprised in the interval 4nm to 6nm, preferably the thickness of the well equals 5nm.

18. A III-V materials quantum well according to any of the claims 12 to 13, wherein:

- x equals 0.09,
- a thickness of the well is comprised in the interval 4nm to 6nm, preferably the thickness of the well equals 5nm.

19. A III-V materials quantum well according to any of the claims 12 to 13, wherein:

- x equals 0.095,
- a thickness of the well is comprised in the interval 4nm to 6nm, preferably the thickness of the well equals 5nm.

20. A III-V materials quantum well according to any of the claims 12 to 13, wherein:

- x equals 0.1,
- a thickness of the well is comprised in the interval 4nm to 6nm, preferably the thickness of the well equals 4nm.

21. A III-V materials quantum well according to any of the claims 12 to 13, wherein:

- x equals 0.11,
- a thickness of the well is comprised in the interval 4nm to 6 nm, preferably the thickness of the well equals 6nm.

22. A III-V materials quantum well according to any of the claims 12 to 13, wherein:

- x equals 0.12,
- a thickness of the well is comprised in the interval 4nm to 6 nm, preferably the thickness of the well equals 6nm.

**23.** A semiconductor device comprising a III-V materials quantum well according to any of the claims 12 to 22.

**24.** A semiconductor device according to claim 23 wherein said semiconductor device is a laser diode.

**25.** A semiconductor device according to claim 23 wherein said semiconductor device is a light-emitting diode.

**Fig. 1**

**Fig. 2a**

EP 3 624 205 A1

Fig. 2b

Fig. 3

Fig. 4

Fig. 5

Fig. 6

Europäisches
Patentamt

European
Patent Office

Office européen
des brevets

# EUROPEAN SEARCH REPORT

Application Number

EP 18 30 6199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AL-JABR A A ET AL: "Red to green emitters from InGaP/InAlGaP laser structure by strain-induced quantum-well intermixing", PROCEEDINGS OF SPIE; [PROCEEDINGS OF SPIE ISSN 0277-786X VOLUME 10524], SPIE, US, vol. 9892, 28 April 2016 (2016-04-28), pages 98921B-98921B, XP060069742, DOI: 10.1117/12.2225164 ISBN: 978-1-5106-1533-5 * sections 1-5; figures 1-9 * | 1-25 | INV. H01L33/00 H01L33/06 H01L33/30 H01S5/343 H01S5/34 |
| X | US 2002/104996 A1 (KUO LI-HSIN [TW] ET AL) 8 August 2002 (2002-08-08) * paragraph [0022] - paragraph [0040]; figure 2 * * paragraph [0041] - paragraph [0046]; figure 3 * | 1-7 | |
| X | US 5 396 508 A (BOUR DAVID P [US] ET AL) 7 March 1995 (1995-03-07) * column 3, line 46 - column 4, line 16; figure 1 * * column 5, line 6 - line 11 * | 12,23-25 | TECHNICAL FIELDS SEARCHED (IPC) H01L H01S |

The present search report has been drawn up for all claims

| Place of search | Date of completion of the search | Examiner |
|---|---|---|
| The Hague | 19 February 2019 | Franssen, Gijs |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 30 6199

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2019

| Patent document cited in search report | | | Publication date | Patent family member(s) | | Publication date |
|---|---|---|---|---|---|---|
| US 2002104996 | A1 | | 08-08-2002 | NONE | | |
| US 5396508 | A | | 07-03-1995 | JP | 3251386 B2 | 28-01-2002 |
| | | | | JP | H06125142 A | 06-05-1994 |
| | | | | US | 5396508 A | 07-03-1995 |

EPO FORM P0459

For more details about this annex : see Official Journal of the European Patent Office, No. 12/82